(19)

**Europäisches Patentamt**
**European Patent Office**
**Office européen des brevets**

(11) **EP 4 589 849 A1**

(12) **EUROPEAN PATENT APPLICATION**

(43) Date of publication:
23.07.2025 Bulletin 2025/30

(21) Application number: 24386005.3

(22) Date of filing: 16.01.2024

(51) International Patent Classification (IPC):
*H03M 1/06* ^(2006.01)    *H03M 1/12* ^(2006.01)

(52) Cooperative Patent Classification (CPC):
H03M 1/1215; H03M 1/0658; H03M 1/0678

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Hamilton Sundstrand Corporation**
**Charlotte, NC 28217 (US)**

(72) Inventors:
• **SKOULAXINOS, Stefanos**
**Huntington**
**Cannock, WS12 4UR (GB)**
• **BEDDER, Ian**
**Stoney Stanton**
**Leicester, LE9 4WH (GB)**

(74) Representative: **Dehns**
**10 Old Bailey**
**London EC4M 7NG (GB)**

(54) **TIME-INTERLEAVED ANALOGUE-TO-DIGITAL CONVERTERS (ADCS)**

(57)    A time-interleaved analogue-to-digital converter (1) including a first analogue-to-digital converter (2a), a second analogue-to-digital converter (2b), and a third analogue-to-digital converter (2c), each arranged to sample an analogue input (4) and produce a respective digital output (8a, 8b, 8c) based on the sampled analogue input (4), and also including a signal interleaving portion (10), arranged to combine the digital outputs (8a, 8b, 8c) from the analogue-to-digital converters to produce a digital output signal (14). The time-interleaved analogue-to-digital converter (1) is configured for operation both in an operational mode, and in a compensation mode when the third analogue-to-digital (2c) converter is non-functional. In the operational mode, the first and second analogue-to-digital converter (2a, 2b) sample the analogue input (4) respectively at a first frequency and a second frequency. In the compensation mode, the first and second analogue-to-digital converter (2a, 2b) sample the analogue input (4) respectively at a third frequency and a fourth frequency. The third frequency is higher than the first frequency, and the fourth frequency is higher than the second frequency.

Figure 1

# Description

Technical field

This disclosure relates to time-interleaved analogue-to-digital converters and methods of operating them.

Background

An analogue-to-digital converter (ADC) is a system that converts an analogue signal into a digital signal. It is known to arrange several analogue to digital converters in parallel, each sampling at different instants, and then to combine their outputs together to reconstruct an output signal which is the digitized analogue input of the ADC (e.g. by plotting a graph of each output relative to its respective sampling time). This "time-interleaved" arrangement of ADCs achieves a higher throughput of the overall arrangement without increasing the clock frequency of the individual ADCs. This is effective since there is a fundamental limit to the maximum sampling speed of a single ADC.

It is possible that one or more ADCs within the time-interleaved ADC topology may become faulty or may fail, for example due to component aging, harsh environmental conditions such as extreme temperatures or high humidity, or an unexpected analogue stress, for example caused by a voltage spike. In case one or more of the individual ADCs fails, such an interleaved ADCs may become non-functional, or its digital output may become compromised, e.g. be less accurate or contain more noise.

It is a goal of the present disclosure to provide a time-interleaved analogue-to-digital converter which addresses some of these shortcomings.

Summary

According to a first aspect of this disclosure, there is provided a time-interleaved analogue-to-digital converter comprising:

a first analogue-to-digital converter, arranged to sample an analogue input and produce a digital output based on the sampled analogue input;
a second analogue-to-digital converter, arranged to sample the analogue input and produce a digital output based on the sampled analogue input;
a third analogue-to-digital converter, arranged to sample the analogue input and produce a digital output based on the sampled analogue input; and
a signal interleaving portion, arranged to combine the digital outputs from the first analogue-to-digital converter and the second analogue-to-digital converter to produce a digital output signal;

the time-interleaved analogue-to-digital converter configured for operation both in an operational mode, and in a compensation mode, wherein the time-interleaved analogue-to-digital converter is configured to operate in the compensation mode when the third analogue-to-digital converter is non-functional;

wherein, in the operational mode, the first analogue-to-digital converter is arranged to sample the analogue input at a first frequency and the second analogue-to-digital converter is arranged to sample the analogue input at a second frequency; and

wherein, in the compensation mode, the first analogue-to-digital converter is arranged to sample the analogue input at a third frequency and the second analogue-to-digital converter is arranged to sample the analogue input at a fourth frequency, wherein the third frequency is higher than the first frequency, and wherein the fourth frequency is higher than the second frequency.

Further according to this disclosure, there is also provided a method of operating a time-interleaved analogue-to-digital converter, comprising:

in a compensation mode in which at least one analogue-to-digital converter of the time-interleaved analogue-to-digital converter is non-functional, increasing the sampling frequency of at least two of the remaining functional analogue-to-digital converters (optionally all of the remaining functional analogue-to-digital converters) of the time-interleaved analogue-to-digital converter, compared to their respective operating frequencies in an operational mode.

The time-interleaved analogue-to-digital converter is configured to operate in the compensation mode when the third analogue-to-digital converter is non-functional. By functional it will be understood that the analogue-to-digital converter is able to operate to convert an analogue input to a digital output to within a tolerable level of accuracy. Conversely, a non-functional analogue-to-digital converter is one unable (at a given time) to operate in this way. Thus, by increasing the sampling rates of the first and second analogue-to-digital converters (optionally all functional analogue-to-digital converters) in the compensation mode, this (partially or fully) compensates for the loss of samples from the third, non-functional (i.e. faulty) analogue-to-digital converter.

The time-interleaved analogue-to-digital converter may be configured to operate in the compensation mode when any of the first analogue-to-digital converter, the second analogue-to-digital converter and the third analogue-to-digital converter are non-functional (and to increase the sampling frequency of the remaining functional analogue-to-digital converters accordingly). For example, if the first analogue-to-digital converter is non-functional, in the compensation mode the sampling frequencies of the second analogue-to-digital converter and the third analogue-to-digital converter are increased, provided they are both still functional.

In some examples, the time-interleaved analogue-to-digital converter is configured to operate in the operational mode when all analogue-to-digital converters of the time-interleaved analogue-to-digital converter are functional. Thus, the operational mode refers to the mode of normal operation of the time-interleaved analogue-to-digital converter in which all of its component analogue-to-digital converters function successfully.

It is described herein above that the sampling frequency of at least two analogue-to-digital converters of the time-interleaved analogue-to-digital converter are increased, in the compensation mode. This is advantageous since by increasing the frequency of more than one analogue-to-digital converter, the sampling frequency of each needs to be increased less (to achieve the same level of compensation) than if only one analogue-to-digital converter were adjusted to compensate. Thus, the overhead required on the sampling frequency of each analogue-to-digital converter is lower.

In order to minimize the required increase in sampling frequency of the analogue-to-digital converters, it is preferable if the sampling frequency of all functional analogue-to-digital converters is increased to compensate for any non-functional analogue-to-digital converters. Thus, in some examples the time-interleaved analogue-to-digital converter is configured such that all functional analogue-to-digital converters sample the analogue input at a higher frequency in the compensation mode than in the operational mode. Dividing the sampling rate increase across all functional ADCs is beneficial because there is a limit of how much an ADC sampling rate can be increased. Furthermore, keeping the switching frequency of sampling signals relatively low using this method maintains the signals travelling on a digital board providing the ADC at a low frequency, which reduces the electro-magnetic interference on the board. Not requiring high frequency signals also reduces the difficulty of designing the digital board.

By arranging the first and second analogue-to-digital converters to sample at a higher frequency in a compensation mode than in the (normal) operational mode, the time-interleaved analogue-to-digital converter is able to compensate for the non-functioning of one or more other analogue-to-digital converters of the time-interleaved analogue-to-digital converter. Without any compensation, the total (or overall) sampling rate of the time-interleaved analogue-to-digital converter would decrease when one or more of the analogue-to-digital converters was non-functional (at a given time). However, according to the present disclosure this total sample rate is increased, relative to if no compensation action was taken, by increasing the sampling frequency of the functional analogue-to-digital converters. By increasing the sampling rate of the functional ADCs in an interleaved system after one or more ADCs has failed the time-interleaved ADC can maintain the overall system sampling rate i.e. allow the system to function as before the ADC/ADCs has failed.

It will be understood that although referred to herein simply as analogue-to-digital converters of the time-interleaved analogue-to-digital converter, these individual analogue-to-digital converters which together provide the time-interleaved analogue-to-digital converter may also be referred to as sub-analogue-to-digital converters.

In some examples, the first frequency and the second frequency (i.e. at which the first and second analogue-to-digital converters sample in the operational mode) are the same. In some examples, all analogue-to-digital converters of the time-interleaved analogue-to-digital converter are arranged (i.e. when functional) to sample at the same frequency in the operational mode. In reality, minor errors may cause the analogue-to-digital converters to sample at slightly different frequencies to each other, but nonetheless it will be understood that they are arranged such as to sample at the same frequency.

In some examples, the third frequency and the fourth frequency (i.e. at which the first and second analogue-to-digital converters sample in the compensation mode) are the same. In some examples, all functional analogue-to-digital converters of the time-interleaved analogue-to-digital converters are arranged (i.e. when functional) to sample at the same frequency in the compensation mode (a frequency higher than the sampling frequency in the operational mode).

The sampling frequency of an analogue-to-digital converter will be understood as the number of times in a given time period (e.g. per second) that that particular analogue-to-digital converter samples the analogue input, and produces a respective digital output based on that analogue input. The frequency is inversely related to the time period, T, between successive (i.e. immediately adjacent in time) instances of a particular analogue-to-digital converter sampling the analogue input. Each analogue-to-digital converter may be arranged to receive a respective (periodic) timing signal. Each analogue-to-digital converter may be triggered to sample the analogue input by a rising edge (e.g. a peak or spike) in its respective timing signal. It will be understood in this case that the frequency of the timing signal corresponds to the sampling frequency of the corresponding analogue-to-digital converter, and that the sampling frequency of the analogue-to-digital converter may be adjusted by adjusting the corresponding timing signal. The timing signal may be received by the analogue-to-digital converter from an external source (which may be one external source supplying the timing signals to all of the analogue-to-digital converters, or may be a separate source of each analogue-to-digital converter), or it may be received internally from a component which forms part of the analogue-to-digital converter.

It will furthermore by understood that the total, or overall, operational sampling rate of the time-interleaved analogue-to-digital converter (i.e. in the operational mode when all analogue-to-digital converters are functional) is the sum of the sampling frequencies of all of the analogue-to-digital converters that are part of the time-interleaved analogue-to-digital converter. At a given time, the total sampling rate of the time-interleaved analogue-to-digital converter is the sum of the sampling frequencies of all of the analogue-to-digital converters that are functional at that time,

Where all of the analogue-to-digital converters of the time-interleaved analogue-to-digital converter sample at the same frequency, the total sampling rate of the time-interleaved analogue-to-digital converter is the sampling frequency of one of the analogue-to-digital converters, multiplied by the number of (functional) analogue-to-digital converters in the time-interleaved analogue-to-digital converter.

The signal interleaving portion is arranged to combine the digital outputs from the first analogue-to-digital converter and the second analogue-to-digital converter (i.e. from at least the first and second analogue-to-digital converters) to produce the digital output signal. It will be appreciated that although arranged to combine the outputs of these converters, it does so in a given instance only if the converter is functional. The signal interleaving portion may be arranged to combine the digital outputs from the first analogue-to-digital converter and the second analogue-to-digital converter and also the third analogue-to-digital converter to produce the digital output signal. The signal interleaving portion may be arranged to combine the digital outputs of all functional analogue-to-digital converters to produce the digital output signal.

It is particularly advantageous if the total sampling frequency is maintained above a threshold level, since this ensures that the digital output signal from the signal interleaving portion is reasonably accurate - if the total sampling frequency of the time-interleaved analogue-to-digital converter drops too low, the digital output signal will not accurately reflect the analogue input signal.

It may be particularly advantageous if the total sampling frequency is maintained (approximately) at least at the same level which it is at in the operational mode (the total operational sampling frequency), even where one or more of the analogue-to-digital converters is non-functional. Thus, in some examples, the frequencies of the analogue-to-digital converters are increased in the compensation mode such that a total sampling frequency of the time-interleaved analogue-to-digital converter in the compensation mode is at least as high as in the operational mode. Optionally, the total sampling frequency of the time-interleaved analogue-to-digital converter in the operational mode is the same as the total sampling frequency in the compensation mode.

It will be appreciated that the total operational sampling frequency is lower than the highest possible sampling frequency of the time-interleaved analogue-to-digital converter, since in order to allow the sampling frequencies to be increased in the compensation mode, each analogue-to-digital converter is not operating at its maximum possible sampling frequency in the operational mode (i.e. there is headroom on the sampling rate of each analogue-to-digital converter in the operational mode).

In order to achieve a total sampling frequency in the compensation mode that is at least as high as the total operational sampling frequency, the sampling frequency of each analogue-to-digital converter in the operational mode may be multiplied by a respective ratio to calculate its sampling frequency in the compensation mode. The ratio may be the total number of analogue-to-digital converters in the time-interleaved analogue-to-digital converter, divided by the number of currently-functional analogue-to-digital converters in the time-interleaved analogue-to-digital converter. It will be understood that the number of currently-functional analogue-to-digital converters in the time-interleaved analogue-to-digital converter is calculated by subtracting the number of currently non-functional analogue-to-digital converters from the total number of analogue-to-digital converters in the time-interleaved analogue-to-digital converter.

There may be situations in which it is not possible to increase the sampling frequencies of the analogue-to-digital converters, as described above, for example if there is insufficient headroom available on the sampling rate to increase the sampling frequency (further). It is advantageous in such a situation if a further method is applied to (partially or fully) compensate for a non-functional analogue-to-digital converter, so that the overall time-interleaved analogue-to-digital converter may continue to function with reasonable accuracy.

Thus, in some examples, the analogue-to-digital converters of the time-interleaved analogue-to-digital converter, comprising the first and second analogue-to-digital converters, are arranged to sample the analogue input sequentially in a sampling sequence, wherein the time-interleaved analogue-to-digital converter is configured for operation in a data-interpolation mode in the event that at least one of the analogue-to-digital converters is in a non-functional state;

wherein, in the data-interpolation mode, the time-interleaved analogue-to-digital converter is arranged to estimate a value for a digital output associated with the at least one non-functional analogue-to-digital converter by interpolating based on values of the digital outputs of the analogue-to-digital converters arranged to sample before and after the at least one non-functional analogue-to-digital converter in the sampling sequence.

It will be understood that although the digital output of the non-functional analogue-to-digital converter is referred to, this does not refer to an output actually made from the non-functional analogue-to-digital converter (it may in practice not produce any output since it is non-functional), rather this refer to estimating what the digital output of that analogue-to-digital converter would have been at that sampling instance had it been functional.

Similarly, in some examples of the method, the time-interleaved analogue-to-digital converter comprises at least two analogue-to-digital converters arranged to sample an analogue input sequentially in a sampling sequence, and output a respective digital output based on the sampled analogue input;
the method comprises, in a data-interpolation mode in which at least one of the analogue-to-digital converters is non-functional, estimating a value for a digital output associated with the at least one non-functional analogue-to-digital converter by interpolating based on values of the digital outputs of the analogue-to-digital converters arranged to sample before and after the at least one non-functional analogue-to-digital converter in the sampling sequence.

This technique also provides an advantageous way to compensate for missing data from a non-functional analogue-to-digital converter. It will be understood that compensating for missing data from a non-functional analogue-to-digital converter by interpolation may be used advantageously independently of the method described above in which sampling frequency of analogue-to-digital converters is increased. Thus, according to a second aspect of the present disclosure, there is provided a time-interleaved analogue-to-digital converter, comprising:

at least two analogue-to-digital converters, arranged to sample an analogue input sequentially in a sampling sequence, and output a respective digital output based on the sampled analogue input;

    the time-interleaved analogue-to-digital converter configured for operation in a data-interpolation mode when (i.e. in the event that) at least one of the analogue-to-digital converters is in a non-functional state;
    wherein in the data-interpolation mode the time-interleaved analogue-to-digital converter is arranged to estimate a value for the digital output associated with the at least one non-functional analogue-to-digital converter by interpolating based on values of the digital outputs of the analogue-to-digital converters arranged to sample before and after the at least one non-functional analogue-to-digital converter in the sampling sequence.

Similarly, according to this disclosure, there is also provided a method of operating a time-interleaved analogue-to-digital converter, wherein the time-interleaved analogue-to-digital converter comprises at least two analogue-to-digital converters, arranged to sample an analogue input sequentially in a sampling sequence, and output a respective digital output based on the sampled analogue input;
the method comprising:
in a data-interpolation mode in which at least one of the analogue-to-digital converters is non-functional, estimating a value for the digital output associated with the at least one non-functional analogue-to-digital converter by interpolating based on values of the digital outputs of the analogue-to-digital converters arranged to sample before and after the at least one non-functional analogue-to-digital converter in the sampling sequence.

It will be understood that features of the aspects described above may also be present in these aspects, and conversely the features described below may also be present in the aspects described above.

In some examples, each analogue-to-digital converter in the sampling sequence may be arranged to sample at the same sampling frequency. The time period between consecutive analogue-to-digital converters sampling in the sampling sequence may be the same for each pair of analogue-to-digital converters (i.e. all analogue-to-digital converters in the sampling sequence may sample at equally spaced times relative to each other). This simplifies the estimation of missing data from a non-functional analogue-to-digital converter.

It will be understood that the sampling sequence refers to an ordering in which the analogue-to-digital converters take samples (e.g. first, then second, then third) repeatedly. It may also refer to the specific timings with which the samples are taken. A particular section of the sampling sequence (i.e. one run-through), with each functional analogue-to-digital converter taking one sample, may be referred to as a sampling cycle.

Where it is stated that interpolation is based on values of the digital outputs of the analogue-to-digital converters that are arranged to sample before and after the at least one non-functional analogue-to-digital converter, it will be appreciated that these analogue-to-digital converters need not be arranged to sample immediately before and after the given non-functional analogue-to-digital converter in the sampling sequence, but rather that one appears somewhere before the particular non-functional analogue-to-digital converter in the sampling sequence and another appears after. However, preferably they come from the same sampling cycle (i.e. they are from the closest instance in time of that functional analogue-to-digital converter taking a sample).

In particular, the samples may not come from the immediately preceding or following analogue-to-digital converters in the sampling sequence, since there may be multiple analogue-to-digital converters adjacent to each other in the sampling sequence which are both or all non-functional.

In some examples, in the data-interpolation mode, the time-interleaved analogue-to-digital converter is arranged to estimate a value for the digital output associated with a non-functional analogue-to-digital converter of the at least one non-functional analogue-to-digital converter by interpolating based on values of the digital outputs of the analogue-to-digital converters arranged to sample immediately before the non-functional analogue-to-digital converter in the sampling sequence and immediately after the non-functional analogue-to-digital converter in the sampling sequence (i.e. the adjacent samples in the sampling sequence). This occurs only where a non-functional analogue-to-digital converter is isolated in the sampling sequence (i.e. not adjacent to one or more other non-functional analogue-to-digital converters).

For example, the sampling sequence may comprise the time-interleaved analogue-to-digital converter sampling in the order of a first analogue-to-digital converter, a second analogue-to-digital converter and a third analogue-to-digital converter (of the at least two analogue-to-digital converters). In the data-interpolation mode, in which the second analogue-to-digital converter may be non-functional, the time-interleaved analogue-to-digital converter may be arranged to estimate a value for the digital output associated with the second analogue-to-digital converter by interpolating based on values of the digital outputs of the first analogue-to-digital converter and the third analogue-to-digital converter.

In other examples, in the data-interpolation mode the time-interleaved analogue-to-digital converter is arranged to estimate a value for the digital output associated with the at least one non-functional analogue-to-digital converter by interpolating based on values of the digital outputs of the analogue-to-digital converter arranged to sample immediately before one of the non-functional analogue-to-digital converters and of the analogue-to-digital converter arranged to sample immediately after another one of the non-functional analogue-to-digital converter in the sampling sequence. Thus, where more than one non-functional analogue-to-digital converter are adjacent to each other in the sampling sequence, the data outputs from the last functional analogue-to-digital converter before the series of non-functional analogue-to-digital converters and the first functional analogue-to-digital converter after the series of non-functional analogue-to-digital converters are used to interpolate for the estimated digital output from each of the non-functional analogue-to-digital converters in the series.

In some examples, the sampling sequence comprises the time-interleaved analogue-to-digital converter sampling in the order of first analogue-to-digital converter, second analogue-to-digital converter, third analogue-to-digital converter and fourth analogue-to-digital converter. In the data-interpolation mode, in which the second and third analogue-to-digital converters may be non-functional, the time-interleaved analogue-to-digital converter may be arranged to estimate a value for the digital outputs associated, respectively, with the second and third analogue-to-digital converters by interpolating based on values of the digital outputs of the first analogue-to-digital converter and the fourth analogue-to-digital converter.

In some examples the value for the digital output associated with the at least one non-functional analogue-to-digital converter is estimated by linear interpolation. This provides a particularly simple method of estimating the missing data. Other types of (non-linear) interpolation may alternatively be used, depending on what is most suitable for estimating the analogue input.

In some examples, the analogue-to-digital converter arranged to sample before the at least one non-functional analogue-to-digital converter in the sampling sequence produces a first digital output, wherein the analogue-to-digital converter arranged to sample after the at least one non-functional analogue-to-digital converter in the sampling sequence produces a second digital output. In some examples, the value for the digital output associated with a first non-functional analogue-to-digital converter of the at least one non-functional analogue-to-digital converter is calculated by dividing the difference between the first digital output and the second digital output by the number of non-functional analogue-to-digital converters. For example, referring to the example above in which the second analogue-to-digital converter is non-functional, the time-interleaved analogue-to-digital converter may be arranged to estimate a value for the digital output associated with the second analogue-to-digital converter by dividing the difference between the first digital output and the second digital output by two.

It will be understood that here the number of non-functional analogue-to-digital converters refers to the number of non-functional analogue-to-digital converters in the sampling sequence that are between the analogue-to-digital converter that produces the first digital output and the analogue-to-digital converter that produces the second digital output (i.e. the number between those two particular analogue-to-digital converters in the sampling sequence - rather than the total number of non-functional analogue-to-digital converter within the time-interleaved analogue-to-digital converter at a given time).

It will be appreciated that where the time-interleaved analogue-to-digital converter (or components thereof) is described as being configured to carry out certain steps, the method may likewise comprise the corresponding step. Similarly, the device may be configured to carry out any of the method steps referred to above.

Detailed description

Certain preferred examples of this disclosure will now be described, by way of example only, with reference to the accompanying drawings, in which:

Figure 1 is a schematic diagram of a time-interleaved ADC to which the invention may be applied;
Figure 2 is a diagram showing the sample timings of the time-interleaved ADC of Figure 1 during normal operation;
Figure 3 is a diagram showing the sample timings of the time-interleaved ADC of Figure 1 during fault-compensation operation, according to the present disclosure; and
Figure 4 is a diagram demonstrating estimation of missing data by interpolation, according to the present disclosure.

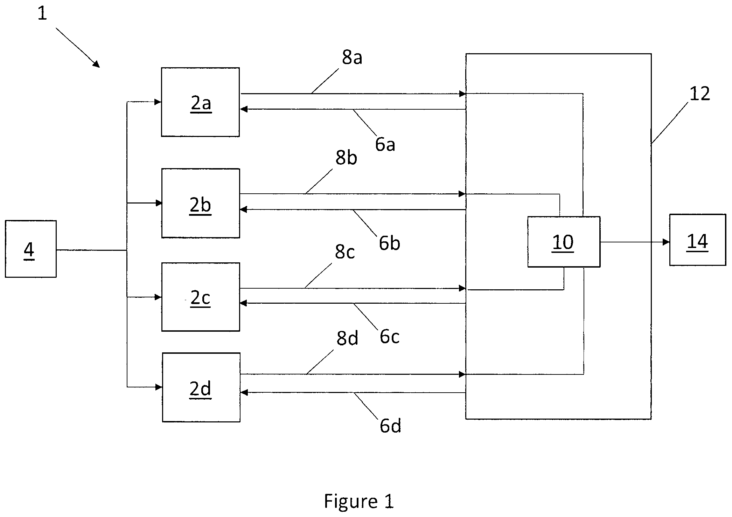

Figure 1 shows a time-interleaved analogue-to-digital converter 1. Analogue-to-digital converter may be abbreviated to ADC. In this example, the time-interleaved ADC 1 includes three individual analogue-to-digital converters - a first ADC 2a, a second ADC 2b, and a third ADC 2c. The time-interleaved ADC 1 receives a sampled analogue signal at its analogue input 4.

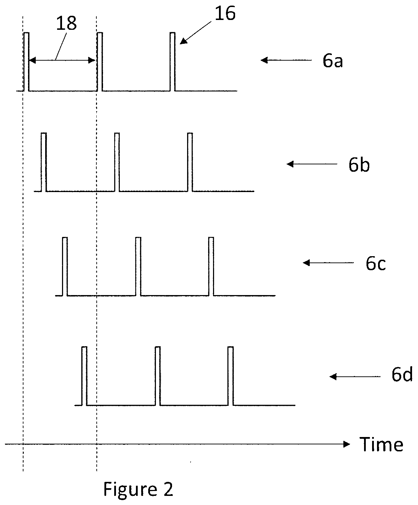

In this example, each ADC 2a, 2b, 2c receives a corresponding individual timing signal 6a, 6b, 6c which dictates the sample timings (i.e. when and at what frequency) with which that ADC samples the analogue input 4. A first timing signal 6a is provided to the first ADC 2a, and likewise for the other two. These timing signals 6a, 6b, 6c, also referred to as sampling clocks, are shown in greater detail in Figure 2, and are described further below.

Each ADC 2a, 2b, 2c produces a respective digital output 8a, 8b, 8c based on the analogue input 4. These signals are interleaved by a signal interleaving portion 10, so as to reconstruct a digital output signal 14 which encodes the analogue input 4. In particular, the signals are interleaved by charting each digital output 8a, 8b, 8c, relative to its respective sample time, to give an overall digital output signal 14. In this example the signal interleaving portion 10 is located within a field programmable gate array (FPGA) or a digital signal processor (DSP) 12.

Example timing signals 6a, 6b, 6c, 6d during normal operation of the time-interleaved ADC are represented in Figure 2.

The sharp peaks or spikes 16 in each timing signal trigger the corresponding ADC 2a, 2b, 2c, 2d to sample the analogue input 4. Since these timing signals 6a, 6b, 6c trigger the associated ADC to sample the analogue input 4, they dictate, and therefore represent, the sample timings of each ADC (i.e. the frequency, period, and relative time offset of sampling). As can be seen, the timing signals 6a, 6b, 6c, 6d are staggered in time relative to each other, so that each ADC 2a, 2b, 2c, 2d is sampling the analogue signal 4 at a different time (i.e. non-simultaneously).

In this example, each timing signal 6a, 6b, 6c, 6d has the same frequency and therefore the same period 18 between samples for a particular ADC. Dashed lines representing this period relative to the first timing signal 6a are shown in Figure 2 so that the relative positions of the other timing signals 6b, 6c, 6d can be seen more clearly.

It can be seen that in one period 18 of the timing signal 6a, referred to as T, there is a single peak of the other three timing signals 6b, 6c, 6d, each offset from the other. Thus, each ADC 2a, 2b, 2c, 2d samples once per time period T, and each has a sampling frequency of f=1/T, meaning that it samples f times per second. Since in this example there are a total of four ADCs 2a, 2b, 2c, 2d the time-interleaved ADC 1 overall samples 4f times per second (or more generally samples at a frequency of N*f, where N is the number of ADCs within the time-interleaved ADC, and f is the frequency of the timing signal(s)).

In the event that one of the ADCs, for example the third ADC 2c, fails (i.e. becomes non-functional), this results in a decrease in sampling frequency of the time-interleaved ADC 1, and also means that, if no remedial action is taken, the samples are no longer being taken by the ADCs at regular, equally spaced intervals. This can give rise to problematic harmonics in the output signal. If a time-interleaved ADC is used in safety critical components of devices, for example aircraft, failure of one of the ADCs within the time-interleaved ADC may mean that the component which uses it must be brought offline and replaced with a back-up method. This may result in an aircraft journey having to be prematurely terminated.

The present disclosure provides methods of compensating for failure of one or more ADCs 2a, 2b, 2c, 2d within the time-interleaved ADC, and thereby preventing the overall time-interleaved ADC 1 from failing in at least some circumstances.

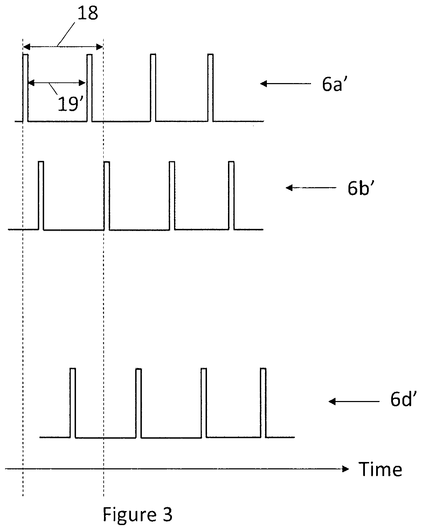

A first aspect of the present disclosure is demonstrated in Figure 3. This shows the timing signals 6a', 6b', 6d' for the time-interleaved ADC 1 of Figure 1, when operated in a compensation mode of operation. No timing signal is shown for the third ADC 2c, since in this example it is the third ADC 2c which has failed.

In the compensation mode, the frequency of the timing signals 6a', 6b', 6c' of the remaining (non-failed) ADCs 2a, 2b, 2d is increased, so that the sample timings of each ADC 2a, 2b, 2d increase in frequency. This helps to compensate for the lower sampling frequency caused by the absence of any samples from the third ADC 2c.

In this example, the frequency of each of the compensated timing signals 6a', 6b', 6d' has been increased such that the sample rate of the time-interleaved ADC 1 is restored to the same overall sample rate which it has during normal operation (as illustrated in Figure 2).

Thus, in this example, the frequency of each timing signal 6a' has been increased by a factor of 4/3 so that overall the time-interleaved ADC 1 is still sampling 4 times per reference time period 18. The time period 19' of each timing signal is now ¾ of the timing signal period 18 which is used during normal operation.

More generally, in at least some examples, the frequency of the timing signals 6a, 6b, 6c, 6d of all functional ADCs may be increased in compensation mode by an amount such that the overall time-interleaved ADC 1 samples at the same rate which it does during normal operation. In order to do this the sampling frequency of each (functional) ADC is increased from:

$$f \; Samples \, / second$$

the sampling frequency during normal, standard operation, to:

$$\frac{N}{N - N_{faulty}} * f \; Samples \; /second$$

where $N$ is the total number of ADCs 2a, 2b, 2c, 2d within the time-interleaved ADC 1 and $N_{faulty}$ is the number of ADCs of the time-interleaved ADC which are nonoperational, i.e. faulty.

By increasing the sampling frequency of each functional ADC within the time-interleaved ADC, each ADC need only increase its sampling frequency by a relatively small amount in order to partially, or even fully compensate, for the faulty ADC(s). This advantage can therefore be achieved even where there is relatively little headroom available on each of the ADCs to increase its sampling frequency.

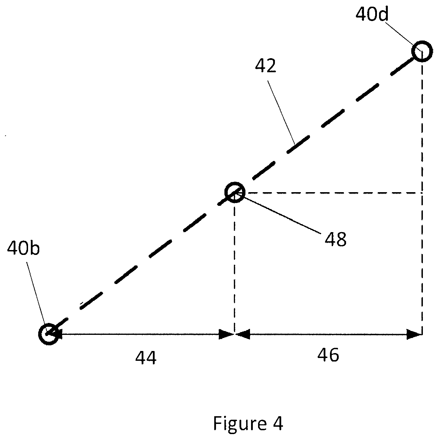

There may be circumstances in which this method cannot be applied, or can no longer be used (e.g. where there is no headroom left to further increase the sampling frequency of the ADCs). Figure 4 illustrates a further advantageous technique which may be used, in addition or alternatively to that described with reference to Figure 3, in order to compensate for faulty ADCs.

In this technique, sample data is collected from ADCs that immediately precede and immediately follow the faulty ADC (or ADCs) in the sampling sequence (i.e. the sampling order). In this example, the sampling sequence is the order first ADC 2a, second ADC 2b, third ADC 2c and then fourth ACD 2d (and so on in a repeating cycle). Considering again a scenario in which the third ADC 2c is faulty, the method uses a first sample 40b, collected from the second ADC 2b, and a second sample 40d, collected from the fourth ADC 2d. The method then interpolates from these two data points to construct a data point for the third ADC 2c, which is then included (i.e. in the time-position where the sample from the third ADC 2c should have been) in the digital output signal from the time-interleaved ADC so that the time-interleaved ADC 1 may continue to function largely as it did before the third ADC 2c failed.

In the illustrated example a linear interpolation is used, as explained further below. However, it will be appreciated that any suitable interpolation may be used, for example a polynomial interpolation. Where data is known about the input analogue signal 4, which sets an expectation that the signal will have a certain type of behaviour, this expected behaviour may be taken into account in selecting the type of interpolation to carry out and/or in estimating a value for the digital output of the non-functional ADC.

In this example, a linear function between the collected data points is assumed, as illustrated by the dashed line 42. In normal operation there is a first time period 44 between the second and third ADCs 2b, 2c taking samples, and there is then a second time period 46 between then the third ADC 2c collects its sample, and when the fourth ADC 2d collects its sample. In this example, the timing signals all have equally spaced peaks, therefore third ADC 2c would normally sample exactly halfway between the times at which the second and fourth ADCs 2b, 2d would take samples, and therefore the first time period 44 and the second time period 46 are equal.

The missing data point 48 is estimated in this example by first taking the difference between the value at the second sample 40d and the first sample 40b, and then dividing this amount by two. This calculated amount is then added to the value of the first sample 40b.

Generally, when linearly interpolating for a single missing data point, the following calculation may be used:

$$ADC_{k+1} = ADC_k + \frac{(ADC_{k+2} - ADC_k)}{2}$$

where k denotes the ADC preceding the faulty ADC in the sampling sequence, k+1 denotes the faulty ADC, and k+2 denotes the ADC which immediately follows the faulty ADC in the sampling sequence. It will be appreciated that where multiple consecutive ADCs of the sampling sequence are faulty, this calculation may be adjusted to interpolate for each of the multiple missing data points, by adjusting the fraction by which the difference is multiplied. Similarly, other calculations may be constructed where a different type of interpolation is used, and a different function, other than linear is assumed.

It will be appreciated by those skilled in the art that the disclosure has been illustrated by describing one or more specific aspects thereof, but is not limited to these aspects; many variations and modifications are possible, within the scope of the accompanying claims.

**Claims**

1. A time-interleaved analogue-to-digital converter comprising:

   a first analogue-to-digital converter, arranged to sample an analogue input and produce a digital output based on the sampled analogue input;
   a second analogue-to-digital converter, arranged to sample the analogue input and produce a digital output based on the sampled analogue input;
   a third analogue-to-digital converter, arranged to sample the analogue input and produce a digital output based on the sampled analogue input; and
   a signal interleaving portion, arranged to combine the digital outputs from the first analogue-to-digital converter and the second analogue-to-digital converter to produce a digital output signal;
   the time-interleaved analogue-to-digital converter configured for operation both in an operational mode, and in a compensation mode, wherein the time-interleaved analogue-to-digital converter is configured to operate in the compensation mode when the third analogue-to-digital converter is non-functional;

wherein, in the operational mode, the first analogue-to-digital converter is arranged to sample the analogue input at a first frequency and the second analogue-to-digital converter is arranged to sample the analogue input at a second frequency; and

wherein, in the compensation mode, the first analogue-to-digital converter is arranged to sample the analogue input at a third frequency and the second analogue-to-digital converter is arranged to sample the analogue input at a fourth frequency, wherein the third frequency is higher than the first frequency, and wherein the fourth frequency is higher than the second frequency.

2. The time-interleaved analogue-to-digital converter of claim 1, wherein the time-interleaved analogue-to-digital converter is configured to operate in the operational mode when all analogue-to-digital converters of the time-interleaved analogue-to-digital converter are functional.

3. The time-interleaved analogue-to-digital converter of any preceding claim, wherein the time-interleaved analogue-to-digital converter is configured such that all functional analogue-to-digital converters sample the analogue input at a higher frequency in the compensation mode than in the operational mode.

4. The time-interleaved analogue-to-digital converter of any preceding claim, wherein the first frequency and the second frequency are the same.

5. The time-interleaved analogue-to-digital converter of any preceding claim, wherein the third frequency and the fourth frequency are the same.

6. The time-interleaved analogue-to-digital converter of any preceding claim, wherein the frequencies of the analogue-to-digital converters are increased in the compensation mode such that a total sampling frequency of the time-interleaved analogue-to-digital converter in the operational mode is the same as the total sampling frequency in the compensation mode.

7. The time-interleaved analogue-to-digital converter of any preceding claim, wherein the analogue-to-digital converters of the time-interleaved analogue-to-digital converter, comprising the first and second analogue-to-digital converters, are arranged to sample the analogue input sequentially in a sampling sequence, wherein the time-interleaved analogue-to-digital converter is configured for operation in a data-interpolation mode in the event that at least one of the analogue-to-digital converters is in a non-functional state;

wherein, in the data-interpolation mode, the time-interleaved analogue-to-digital converter is arranged to estimate a value for a digital output associated with the at least one non-functional analogue-to-digital converter by interpolating based on values of the digital outputs of the analogue-to-digital converters arranged to sample before and after the at least one non-functional analogue-to-digital converter in the sampling sequence.

8. A method of operating a time-interleaved analogue-to-digital converter, comprising:
in a compensation mode in which at least one analogue-to-digital converter of the time-interleaved analogue-to-digital converter is non-functional, increasing the sampling frequency of at least two of the remaining functional analogue-to-digital converters of the time-interleaved analogue-to-digital converter, compared to their respective operating frequencies in an operational mode.

9. The method of claim 8, comprising in the compensation mode, increasing the sampling frequency of all of the remaining functional analogue-to-digital converters of the time-interleaved analogue-to-digital converter, compared to their respective operating frequencies in an operational mode

10. The method of claim 8 or 9, wherein the time-interleaved analogue-to-digital converter comprises at least two analogue-to-digital converters arranged to sample an analogue input sequentially in a sampling sequence, and output a respective digital output based on the sampled analogue input;
the method comprising, in a data-interpolation mode in which at least one of the analogue-to-digital converters is non-functional, estimating a value for a digital output associated with the at least one non-functional analogue-to-digital converter by interpolating based on values of the digital outputs of the analogue-to-digital converters arranged to sample before and after the at least one non-functional analogue-to-digital converter in the sampling sequence.

11. A time-interleaved analogue-to-digital converter, comprising:

at least two analogue-to-digital converters, arranged to sample an analogue input sequentially in a sampling sequence, and output a respective digital output based on the sampled analogue input;
the time-interleaved analogue-to-digital converter configured for operation in a data-interpolation mode when at least one of the analogue-to-digital converters is in a non-functional state; wherein in the data-interpolation mode the time-interleaved analogue-to-digital converter is arranged to estimate a value for the digital output associated with the at least one non-functional analogue-to-digital converter by interpolating based on values of the digital outputs of the analogue-to-digital converters arranged to sample before and after the at least one non-functional analogue-to-digital converter in the sampling sequence.

12. The time-interleaved analogue-to-digital converter of claim 11, wherein the value for the digital output associated with the at least one non-functional analogue-to-digital converter is estimated by linear interpolation.

13. The time-interleaved analogue-to-digital converter of claim 11 or 12, wherein the analogue-to-digital converter arranged to sample before the at least one non-functional analogue-to-digital converter in the sampling sequence produces a first digital output, wherein the analogue-to-digital converter arranged to sample after the at least one non-functional analogue-to-digital converter in the sampling sequence produces a second digital output, and wherein the value for the digital output associated with a first non-functional analogue-to-digital converter of the at least one non-functional analogue-to-digital converter is calculated by dividing the difference between the first digital output and the second digital output by the number of non-functional analogue-to-digital converters.

14. The time-interleaved analogue-to-digital converter of any of claims 11 to 13, wherein, in the data interpolation mode, the time-interleaved analogue-to-digital converter is arranged to estimate a value for the digital output associated with a non-functional analogue-to-digital converter of the at least one non-functional analogue-to-digital converters by interpolating based on values of the digital outputs of the analogue-to-digital converters arranged to sample immediately before the non-functional analogue-to-digital converter in the sampling sequence and immediately after the non-functional analogue-to-digital converter in the sampling sequence.

Figure 1

Figure 2

Figure 3

EP 4 589 849 A1

Figure 4

Europäisches
Patentamt

European
Patent Office

Office européen
des brevets

## EUROPEAN SEARCH REPORT

**Application Number**

EP 24 38 6005

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/264308 A1 (DANSON JOHN JAMES [CA] ET AL) 14 September 2017 (2017-09-14) | 1-6,8,9 | INV.<br>H03M1/06 |
| A | * paragraphs [0003] - [0005] *<br>* paragraphs [0042] - [0043] *<br>* paragraph [0060] *<br>* figure 1 * | 7,10 | H03M1/12 |
| | - - - - - | | |
| X | US 2021/273645 A1 (SJÖLAND HENRIK [SE] ET AL) 2 September 2021 (2021-09-02) | 11-14 | |
| A | * paragraph [0055] *<br>* paragraph [0057] *<br>* paragraphs [0061] - [0063] *<br>* paragraph [0065] *<br>* paragraph [0067] *<br>* paragraph [0069] *<br>* paragraph [0072] *<br>* paragraph [0077] *<br>* paragraph [0079] *<br>* paragraph [0094] *<br>* figures 1,2 * | 7,10 | |
| | - - - - - | | **TECHNICAL FIELDS SEARCHED (IPC)**<br><br>H03M |

The present search report has been drawn up for all claims

| Place of search | Date of completion of the search | Examiner |
|---|---|---|
| The Hague | 18 October 2024 | Rocha, Daniel |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt

European
Patent Office

Office européen
des brevets

**Application Number**

EP 24 38 6005

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

[X] All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 24 38 6005

The Search Division considers that the present European patent application does not comply with the requirements of unity of invention and relates to several inventions or groups of inventions, namely:

1. claims: 1-10

   Maintaining the overall sampling rate of a time-interleaved ADC despite the presence of non-functional sub-ADCs
   - - -

2. claims: 7, 10-14

   Estimating the value of the missing sample due to a non-functional sub-ADC by interpolation.
   - - -

## ANNEX TO THE EUROPEAN SEARCH REPORT
## ON EUROPEAN PATENT APPLICATION NO.

EP 24 38 6005

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2024

| Patent document cited in search report | Publication date | Patent family member(s) | | Publication date |
|---|---|---|---|---|
| US 2017264308 A1 | 14-09-2017 | EP | 3217560 A1 | 13-09-2017 |
| | | US | 2017264308 A1 | 14-09-2017 |
| US 2021273645 A1 | 02-09-2021 | EP | 3844879 A1 | 07-07-2021 |
| | | US | 2021273645 A1 | 02-09-2021 |
| | | WO | 2020043305 A1 | 05-03-2020 |

EPO FORM P0459

For more details about this annex : see Official Journal of the European Patent Office, No. 12/82